# EUROPÄISCHE PATENTSCHRIFT

(11) **EP 0 367 860 B1**
(45) Veröffentlichungstag und Bekanntmachung des Hinweises auf die Patenterteilung: **10.03.1993**
(21) Anmeldenummer: 88118801.5
(22) Anmeldetag: 11.11.1988
(51) Int. Cl.: G01R 23/16

(54) **Verfahren zur Messung der Amplitude eines periodischen zeitabhängigen elektrischen Signales G(t) in einem Signalbereich U(t)**
Amplitude measuring process of a periodic electrical signal G(t) in a band of signals U(t)
Procédé de mesure de l'amplitude d'un signal électrique périodique G(t) dans une plage de signaux U(t)

(43) Veröffentlichungstag der Anmeldung: 16.05.1990
(73) Patentinhaber: Hartmann & Braun Aktiengesellschaft, 60484 Frankfurt am Main (DE)
(72) Erfinder: Vogt, Reinhard, Dr., D-6100 Darmstadt (DE)

(56) Entgegenhaltungen:
- EP-A- 0 269 309
- US-A- 4 031 462
- ELEKTRONIK, Band 34, Nr. 26, 27. Dezember 1985, Seiten 65-69; H.-P. SIEBERT: "Signal-Zerlegungstechniken der Spektrumanalyse"

## Beschreibung

Die Erfindung geht aus von einem Verfahren nach dem Oberbegriff des Anspruches 1.

Zum Bestimmen des Fourierkoeffizienten ist das Integral über eine Periodendauer T des Signales U(t) des Produktes aus den beiden Signalen G(t) und U(t) zu bilden. Zum Bilden dieses Produktes wird über eine geeignete Einrichtung ein elektrisches Signal g(t) erzeugt, dessen Kurvenform mit der von G(t) identisch ist. Zur Lösung dieses Problemes ist es z.B. aus dem Artikel "Signal-Zerlegungstechniken der Spektrumanalyse" von H.P. Siebert in "Elektronik", 26./27.12.1985, S. 65 ff bekannt, das Signal g(t) als analoges Signal zu erzeugen. Das analoge Signal g(t) und das Signalgemisch U(t) werden über analoge Multiplizierer miteinander multipliziert und anschließend analog integriert. Nachteilig hierbei ist, daß Nullpunktdriften und Stabilitätsprobleme im Integrator zu Meßungenauigkeiten führen, wenn sie nicht mit erheblichen Schaltungsaufwand kompensiert werden.

Es ist auch denkbar, das Signal g(t)) als digitales Signal zu erzeugen und das Signalgemisch mit Hilfe eines Analog-Digital-Wandlers zu digitalisieren. Eine digitale Recheneinrichtung übernimmt dann die Multiplikation und Integration der digitalisierten Signale. Da bei der Analog-Digital-Umsetzung auch Oberwellen des Signalgemisches U(t) zu berücksichtigen sind, ist zur Erfüllung des Shannonschen Abtasttheorems ein schnell abtastender Wandler und eine entsprechend leistungsfähige Signalverarbeitung erforderlich.

Die Aufgabe der Erfindung besteht darin, ein Verfahren zur Bestimmung der Amplitude des elektrischen Signals G(t) der eingangs erläuterten Art zu schaffen, das keinen schnell abtastenden Wandler benötigt und bei dem die Rechenoperationen mit einfachen elektrischen Mitteln durchgeführt werden können. Erfindungsgemäß wird diese Aufgabe durch die Merkmale des kennzeichnenden Teiles der Patentansprüche 1 oder 2 gelöst.

Im folgenden wird die Erfindung beispielhaft und unter gleichzeitiger Bezugnahme auf die Zeichnung weiter ins einzelne gehend erläutert. In der Zeichnung zeigen
- Fig. 1: schematisch den grundsätzlichen Aufbau einer nach dem erfindungsgemäßen Verfahren arbeitenden Meßvorrichtung mit einem Summierwerk und
- Fig. 2: schemaitsch den grundsätzlichen Aufbau einer nach dem erfindungsgemäßen Verfahren arbeitenden Meßvorrichtung mit einem VOR-/Rückwärtszähler.

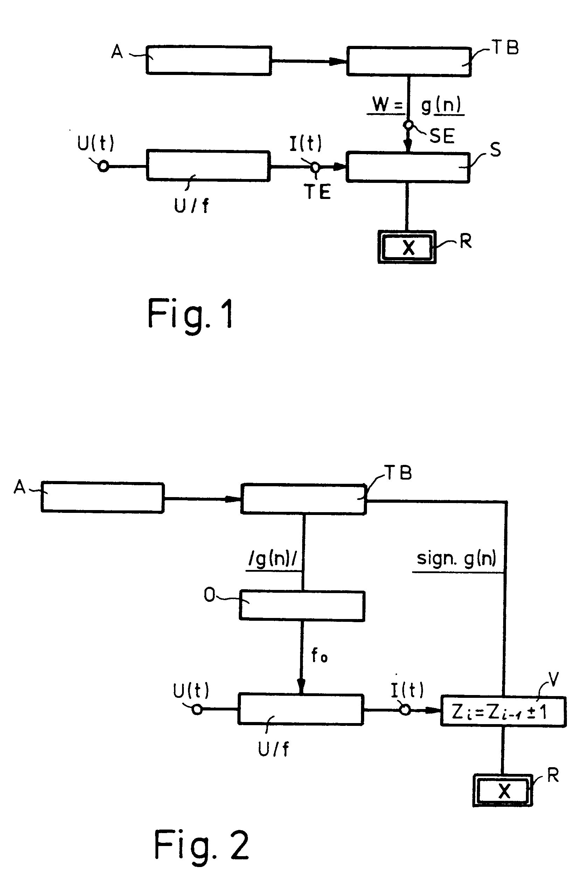

Die Meßeinrichtung nach Fig. 1 besteht aus einem Spannungs-Frequenz-Wandler U/f, aus einem Summierwerk S, einem Register R, in dem das Ergebnis X der Messung gespeichert ist, sowie aus den Baugruppen Adressierung A und Tabelle TB, mit deren Hilfe ein Abtastsignal g(n) erzeugt wird.

Das zu untersuchende Signalgemisch U(t) wird dem Eingang des U/f-Wandlers zugeführt, der aus dem Signalgemisch eine Impulsfolge I(t) erzeugt, deren Frequenz f(t) linear von der augenblicklichen Amplitude von U(t) abhängig ist. Die Impulsfolge I(t) liegt am Takteingang TE des Summierwerkes S, das bei jeder beispielsweise positiven Flanke eines Impulses von I(t) zu dem vorhandenen Zählwert Z (Zi-1) einen an seinem Summiereingang SE anliegenden Wert W hinzuaddiert. Der Summiervorgang läuft über eine volle Periode T des Signalgemisches U(t). Zu Beginn der Periode T ist der Zählwert Z des Summierwerkes S auf Null gesetzt.

Der Wert W am Summiereingang SE ist der jeweils aktuelle Wert der Amplitude eines Abtastsignales g(n). Dieses Abtastsignal g(n) stellt das bereits erläuterte Testsignal g(t) dar mit der Periodendauer T/p und gleicher sinusförmiger Kurvenform wie das Signal G(t), dessen Amplitude gemessen werden soll. Die Folge dieses Summiervorganges ist, daß jede positive Flanke eines Impulses der Impulsfolge I(t) mit der Wichtung des Wertes W, also mit der jeweils aktuellen Amplitude des Abtastsignales g(n), in das Summierwerk S addiert wird. Diese gewichtete Zählung führt dazu, daß am Ende der Periode T der erreichte Zählwert Z dem Integral über dem Produkt U(t) innerhalb g(t) und damit der zu messenden Amplitude des Signales G(t) proportional ist. Dieser Zählwert wird als Ergebnis X in ein Register R übernommen und steht dort zur Weiterverarbeitung zur Verfügung.

Das Abtastsignal g(n) in der Meßvorrichtung nach Fig. 1 repräsentiert das Testsignal g(t); es wird durch n äquidistante Abtastwerte der Funktion g(t) dargestellt, die in der Tabelle TB abgelegt sind. Eine geeignete Adressierungseinrichtung A sorgt dafür, daß die Tabelle p mal zyklisch innerhalb der Periode T und einem festen Phasenbezug zum Signalgemisch U(t) adressiert wird. Am Ausgang der Tabelle TB steht dann für die Dauer eines Abtastintervalles ein konstanter Wert W an, der die Amplitude der Funktion g(t) zu diesem Abtastintervall darstellt.

Die in Fig. 2 dargestellte Meßvorrichtung zur Bestimmung der Amplitude eines periodischen zeitabhängigen elektrischen Signales G(t) besteht aus einem Spannungs-Frequenz-Wandler U/f, aus einem Oszillator O zur Erzeugung einer steuerbaren Mittenfrequenz fo für den U/f-Wandler, aus einem Vor-/Rückwärtszähler V sowie aus den Baugruppen Adressierungseinrichtung A und Tabelle TB, mit deren Hilfe das Vorzeichen und der Betrag der Amplitude des Abtastsignales g(n) gebildet wird.

Dem Eingang des U/f-Wandlers wird ein elektrisches Signalgemisch U(t) zugeführt, welches mit Hilfe des Wandlers in eine Impulsfolge I(t) umgeformt wird, deren veränderliche Frequenz f(t) erstens linear von der augenblicklichen Amplitude des Signalgemisches abhängig ist und zweitens proportional einer externe Mittenfrequenz fo ist. Diese Mittenfrequenz fo liefert ein Oszillator O, dessen Frequenz sich proportional zum aktuellen Wert des Betrages des Abtastsignales g(n) ändert.

Die Impulse der Impulsfolge I(t) werden innerhalb einer Periode T des Signalgemisches U(t) gezählt in dem Vor-/Rückwärtszähler V, dessen Zählrichtung das Vorzeichen Sign g(n) des Abtastsignales g(n) bestimmt. Nach Ablauf der Periode T enthält der Vor-/Rückwärtszähler V, dessen Zählwert zu Beginn der Zählung auf Null gesetzt wird, einen Zählwert Z, der proportional ist dem Integral über dem Produkt U(t) innerhalb g(t). Dieser Zählwert ist damit auch proportional der Amplitude des Signales G(t) und wird als Ergebnis X in ein Register R zur weiteren Veraabeitung übernommen. In der Meßvorrichtung nach Fig. 2 stellt das Abtastsignal g(n) das Testsignal g(t) dar; es wird in der gleichen Weise, wie bei der Meßrichtung nach Fig. 1 erläutert, aus der Tabelle TB generiert, die p mal zyklisch innerhalb der Periode T und einem festen Phasenbezug zum Signalgemisch U(t) von der Adressierungseinrichtung A abgestastet wird, wobei die n äquidistanten Abtastwerte der Funktion g(t) nach Betrag /g(n)/ und Vorzeichen Sign g(n) getrennt ausgegeben werden.

Der besondere Vorteil der Meßeinrichtung nach Fig. 2 besteht darin, daß die gesamte Signalverarbeitung mit gängigen Zähleinrichtungen und einer Tabelle für die Funktion g(t) durchgeführt werden kann, so daß die in digitaler Schaltungstechnik aufbaubare Meßvorrichtung integrierbar ist.

## Patentansprüche

1. Verfahren zum Messen der Amplitude der p-ten Oberwelle G(t) eines bandbegrenzten, nicht sinusförmigen elektrischen Signals U(t) mit der Periode T, bei dem zum Bestimmen des p-ten Fourierkoeffizienten das Produkt aus dem Signal U(t) und einem sinusförmigen Testsignal g(t) mit der Periode T/p gebildet und über eine Periode T integriert wird,
gekennzeichnet durch folgende Verfahrensschritte :
- Das Signal U(t) wird einem Spannungs-Frequenz-Wandler (U/F) zugeführt zum Erzeugen einer Impulsfolge I(t), deren augenblickliche Frequenz f(t) linear von der augenblicklichen Amplitude des Signals U(t) abhängig ist,
- die Impulse der Impulsfolge I(t) werden über eine volle Periode T des Signals U(t) gezählt, indem sie dem Takteingang (TE) eines Summierwerkes (S) zugeführt werden, dessen aktueller Zählwert Z zu Beginn der Periode T auf Null gesetzt ist,
- das Testsignal g(t) wird durch ein Abtastsignal g(n) dargestellt und zur Wichtung der Impulsfolge I(t) dem Summiereingang (SE) des Summierwerkes (S) zugeführt, das mit jedem Impuls der Impulsfolge I(t) zu dem vorhandenen Zählwert den an seinem Summiereingang (SE) anliegenden Wert (W) hinzuaddiert, so daß der ermittelte Zählwert Z des Summierwerkes (S) nach Ablauf einer Periode T dem Integral über das Produkt von U(t) und g(t) und damit der zu messenden Amplitude der Oberwelle G(t) proportional ist und als Ergebnis (X) in ein Register (R) übernommen wird.

2. Verfahren nach dem Oberbegriff des Anspruchs 1, gekennzeichnet durch folgende Verfahrensschritte:
- das Signalgemisch U(t) wird einem Spannungs-Frequenz-Wandler (U/f) zugeführt zum Erzeugen einer Impulsfolge I(t), deren augenblickliche Frequenz f(t) einer externen Mittenfrequenz fo proportional und linear von der augenblicklichen Amplitude des Signales U(t) abhängig ist,
- das Testsignal g(t) wird durch ein Abtastsignal g(n) dargestellt,
- die Mittenfrequenz fo ist proportional zum aktuellen Wert des Betrages des Abtastsignales g(n),
- die Impulse der Impulsfolge I(t) werden über eine volle Periode T des Signalgemisches U(t) gezählt in einem Vor-/Rückwärtszähler (V), dessen Zählwert Z zu Beginn der Periode T auf Null gesetzt ist und dessen Zählrichtung vom Vorzeichen des Abtastsignales Sign. G(n) gesteuert wird, so daß der ermittelte Zählwert Z im Vor-/Rückwärts-Zähler (V) nach Ablauf einer Periode T dem Integral über dem Produkt von U(t) und g(t) und damit der zu messenden Amplitude des Signales G(t) proportional ist und als Ergebnis (X) in ein Register (R) übernommen werden kann.

## Claims

1. Method for the measurement of the amplitude of the pth harmonic G(t) of a bandwidth limited, non-sinusoidal electrical signal U(t) having the period T in which, for the determination of the pth Fourier coefficient, the product of the signal U(t) and a sinusoidal test signal g(t) having the period T/p is formed and integrated over a period T, characterized by the following method steps:
- the signal U(t) is supplied to a voltage to frequency converter (U/f) for the generation of a pulse train I(t) whose instantaneous frequency f(t) is linearly dependent on the instantaneous amplitude of the signal U(t),
- the pulses of the pulse train I(t) are counted over a complete period of the signal U(t) in that they are applied to the clock input (TE) of a summing circuit (S) whose prevailing count value Z is set to zero at the beginning of the period T,
- the test signal g(t) is represented by a sampling signal g(n) and is applied, for the weighting of the pulse train I(t), to the summing input (SE) of the summing circuit (S) which adds the value (W) present on its summing input (SE) to the existing count value at each pulse of the pulse train I(t) so that the count value Z of the summing circuit (S) determined at the end of a period T is proportional to the integral of the product of U(t) and g(t) and thus to the amplitude of the harmonic G(t) being measured and is stored in a register (R) as the result (X).

2. Method in accordance with the first part of Claim 1, characterised by the following method steps:
- the composite signal U(t) is supplied to a voltage to frequency converter (U/f) for the production of a pulse train I(t) whose instantaneous frequency f(t) is proportional to an external mid-frequency fo and is linearly dependent on the instantaneous amplitude of the signal U(t),
- the test signal g(t) is represented by a sampling signal g(n),
- the mid-frequency fo is proportional to the current value of the magnitude of the sampling signal g(n),
- the pulses of the pulse train I(t) are counted during a complete period T of the composite signal U(t) in an up/down counter (V) whose count value Z is set to zero at the beginning of the period T and whose counting direction is controlled by the sign Sign. G(n) of the sampling signal so that, at the end of a period T, the count value Z determined in the up/down counter (V) is proportional to the integral of the product of U(t) and g(t) and thus to the amplitude of the signal G(t) being measured and can be stored as the result (X) in a register (R).

## Revendications

1. Procédé pour mesurer l'amplitude des p^{ième} harmoniques G(t) dans une bande limitée d'un signal électrique non sinusoïdal U(t) avec la période T, procédé dans lequel, pour déterminer le p^{ième} coefficient de Fourier, on forme le produit du signal U(t) par un signal de test sinusoïdal g(t) avec la période T/p et on l'intègre sur une période T, procédé caractérisé en ce que :
- le signal U(t) est appliqué à un convertisseur tension-fréquence (U/F) pour obtenir une succession d'impulsions I(t) dont la fréquence instantanée f(t) dépend linéairement de l'amplitude instantanée du signal U(t).
- les impulsions de la succession d'impulsions I(t) sont comptées sur une période complète T du signal U(t), en ce qu'elles sont appliquées à l'entrée de synchronisation (TE) d'un additionneur (S) dont la valeur de comptage actuelle Z est mise à zéro au début de la période T.
- le signal test g(t) est représenté par un signal d'exploration g(n) et est appliqué pour la pondération de la succession d'impulsions I(t) à l'entrée d'addition (SE) de l'additionneur (S), qui avec chaque impulsion de la succession d'impulsions I(t) ajoute à la valeur de comptage existante la valeur (W) s'appliquant à son entrée d'addition (SE), de sorte que la valeur de comptage Z ainsi obtenue de l'additionneur (S) est proportionnelle, après l'écoulement d'une période T, à l'intégrale sur le produit de U(t) et de g(t), et est donc proportionnelle à l'amplitude à mesurer de l'harmonique G(t), et est prise en charge en tant que résultat (X) dans un registre (R).

2. Procédé selon le préambule de la revendication 1, caractérisé en ce que :
- le mélange de signaux U(t) est appliqué à un convertisseur tension-fréquence (U/f) pour obtenir une succession d'impulsions I(t), dont la fréquence instantanée f(t) est proportionnelle à une fréquence externe moyenne fo et dépend linéairement de l'amplitude instantanée du signal U(t),
- le signal de test g(t) est représenté par un signal d'exploration g(n),
- la fréquence moyenne fo est proportionnelle à la valeur actuelle de la valeur absolue du signal d'exploration g(n),
- les impulsions de la succession d'impulsions I(t) sont comptées sur une période complète T du mélange de signaux U(t) dans un compteur en avant et en arrière (v), dont la valeur de comptage Z est mise à zéro au début de la période T, et dont le sens de comptage est commandé par le signe du signal d'exploration, de sorte que la valeur de comptage Z déterminée dans le compteur en avant et en arrière (V) est, après le déroulement d'une période T, proportionnelle à l'intégrale sur le produit de U(t) par g(t), et donc à l'amplitude à mesurer du signal G(t), et cette valeur de comptage peut être prise en charge dans un registre (R) en tant que résultat (X).
